## Europäisches Patentamt

## European Patent Office

## Office européen des brevets

(19)

(11) Veröffentlichungsnummer : **0 208 956**
**B1**

(12) **EUROPÄISCHE PATENTSCHRIFT**

(45) Veröffentlichungstag der Patentschrift :
28.03.90

(51) Int. Cl.$^5$ : **C 23 C 18/18**

(21) Anmeldenummer : **86108578.5**

(22) Anmeldetag : **24.06.86**

(54) Verfahren zur Metallisierung eines elektrisch schlecht leitenden Substrates aus einem anorganischen Material.

(30) Priorität : 04.07.85 DE 3523960

(43) Veröffentlichungstag der Anmeldung :
21.01.87 Patentblatt 87/04

(45) Bekanntmachung des Hinweises auf die Patenterteilung : 28.03.90 Patentblatt 90/13

(84) Benannte Vertragsstaaten :
AT BE CH DE FR GB IT LI LU NL SE

(56) Entgegenhaltungen :
EP—A— 0 128 476
FR—A— 2 116 376

(73) Patentinhaber : **Licentia Patent-Verwaltungs-GmbH**
**Theodor-Stern-Kal 1**
**D-6000 Frankfurt/Main 70 (DE)**

(72) Erfinder : **Bogenschütz, August-Friedrich, Prof. Dr.**
**rer.nat.**
**Beethovenstrasse 10**
**D-7931 Oberdischingen (DE)**
Erfinder : **Jostan, Josef L., Dr. rer.nat.**
**Haslacherweg 21**
**D-7900 Ulm (DE)**
Erfinder : **Ostwald, Robert, Dr.-Ing.**
**Hasensteige 8**
**D-7900 Ulm (DE)**

(74) Vertreter : **Schulze, Harald Rudolf, Dipl.-Ing. et al**
**Licentia Patent-Verwaltungs-GmbH Theodor-Stern-**
**Kai 1**
**D-6000 Frankfurt/Main 70 (DE)**

EP 0 208 956 B1

Jouve, 18, rue St-Denis, 75001 Paris, France

## Beschreibung

Die Erfindung betrifft ein Verfahren zur Metallisierung eines elektrisch schlecht leitenden Substrates aus einem anorganischen Material nach dem Oberbegriff des Patentanspruchs 1.

Ein wichtiger Schritt zu der Metallisierung von Keramik und keramikähnlichen Substanzen ist eine vorherige Aufschlußbehandlung der Substratoberfläche, um zum einen verschmutzte Oberflächen zu reinigen und zum anderen eine gezielte Aufrauhung mittels spezieller Ätzmedien vorzunehmen. Nur so kann eine gute Haftung der nachfolgenden Metallisierungsschicht erreicht werden, die auf einer teils mechanischen Verankerung, teils auf chemischer Bindung zur Oberfläche beruht.

Für einige Anwendungsfälle, z. B. der Herstellung sogenannter gedruckter Schaltungen auf Substraten aus Keramik, ist es erforderlich, daß die Metallisierung mit eng tolerierten elektrischen Eigenschaften erfolgt. Dafür ist es besonders wichtig, daß zwischen dem Substrat und einer darauf aufgebrachten Metallschicht immer eine im wesentlichen gleiche Grenzschicht vorhanden ist. Denn eine solche Grenzschicht beeinflußt z. B. den sogenannten elektrischen Verlustwinkel einer elektrischen Schaltungsanordnung.

Aus der FR-A- 2 116 376 ist es bekannt, ein gereinigtes Keramiksubstrat, z. B. $Al_2O_3$, zunächst in eine Lösung eines Alkalihydroxids zu tauchen, die Lösung abtropfen und anschließend trocknen zu lassen, z. B. bei einer Temperatur von ungefähr 170 °C. Anschließend erfolgt eine weitere Erwärmung (Nachbehandlung), so daß der trockene Alkalihydroxidfilm schmilzt und dadurch die Oberfläche anätzt.

Ein solches Verfahren hat den Nachteil, daß kein hochgenauer und reproduzierbarer Aufschluß der Oberfläche möglich ist. Denn bei dem Abtropfen der Lösung bildet sich auf der Oberfläche ein ungleichmäßig dicker Lösungsfilm, der zu einer ungleichmäßig dicken Alkalihydroxidschicht führt. Diese bewirkt einen störenden ungleichmäßigen Aufschluß der Oberfläche.

Der Erfindung liegt die Aufgabe zugrunde, ein gattungsgemäßes Verfahren dahingehend zu verbessern, daß in wiederholbarer Weise eine Metallisierung mit genau vorherbestimmbaren Eigenschaften ermöglicht wird, insbesondere bei einer kostengünstigen sowie zuverlässigen industriellen Massenfertigung.

Diese Aufgabe wird gelöst durch die im kennzeichnenden Teil des Patentanspruchs 1 angegebenen Merkmale. Zweckmäßige Ausgestaltungen und/oder Weiterbildungen sind den Unteransprüchen entnehmbar.

Die Erfindung wird im folgenden anhand von Ausführungsbeispielen näher erläutert.

Es ist möglich, bei einem Substrat aus einer beispielhaften, derzeit handelsüblichen $Al_2O_3$-Keramik eine Oberfläche mit einem vorgebbarem Rauhigkeitsgrad (Rauhtiefe) zu erzeugen. Dieses erfolgt durch eine sorgfältige Wahl eines an das Material des Substrates angepaßten Ätzmediums, das aus einem Vorbehandlungsmittel in Kombination mit einer daran angepaßten Nachbehandlung entsteht. Neben der Wahl der Einwirkzeit des Ätzmediums ist es möglich, durch Wahl der Aufbringungsmethode des Vorbehandlungsmittels sowie dessen Aufschlußmittel, in der Nachbehandlung, eine hochgenaue Steuerung des Ätzangriffs der Oberfläche zu erreichen.

Beispielsweise wird bei einem Vorbehandlungsmittel, das aus einer NaOH- oder KOH-haltigen Schmelze besteht im allgemeinen ein Eintauchverfahren bevorzugt, das mit konstanten regelbaren Eintauch- und Ausziehgeschwindigkeiten für das Substrat arbeitet. Weiterhin können in solchen Fällen auch Pulverbeschichtungen der Oberflächen vorgenommen werden, z. B. nach einem sogenannten Panierverfahren, bestehend aus Anfeuchten des Werkstücks mit nachfolgendem Eintauchen in ein Pulver, klebrigem Haften und anschließendem Pulverschmelzen auf dem Substrat. Bei gesättigten, wässrigen alkalischen Lösungen dagegen läßt sich bevorzugt ein horizontal arbeitendes Sprühverfahren anwenden, in manchen Fällen, bei sehr viskosen Lösungen, auch ein Schaumätzen auf schiefer Ebene. Ein besonders gut steuerbares Verfahren ist die Gasphasenätzung, wobei das Substrat bevorzugt in den Dampf eines alkalisch reagierenden Mediums eingebracht wird. Hier kann während der Reaktion der Fortschritt des Oberflächenaufschlusses meßbar verfolgt und zum geeigneten Zeitpunkt die Einwirkung abgebrochen werden. Eine apparativ einfache Anordnung ist der Schleuderaufschluß, der vorwiegend bei wässrigen Lösungen zum Einsatz kommt. Auch das Aufdrucken alkalischer Pasten ist vorteilhaft, da je nach Art und Größe der gewünschten Vorbehandlung eines Keramiksubstrats ein flächenhafter oder partielle Druck nach Art des Siebdrucks möglich ist.

Ein entscheidender Vorteil der Erfindung besteht in dem reproduzierbaren, gezielt abstufbaren Ätzangriff, welcher im einzelnen auf die zu metalisierende Keramikqualität und den speziellen Anwendungsfall abgestimmt wird. Letzteres wird vorzugsweise durch die Reaktionsweise der auf die Keramikoberflächen aufgebrachten Substanzen während einer thermischen oder hydrothermischen Nachbehandlung der beschichteten Keramik festgelegt. Diese Nachbehandlung führt beispielsweise zu einer thermischen Zersetzung der aufgebrachten Verbindung oder zu einer hydrolytischen Spaltung, somit also zu einer Verdünnung oder zu einer Konzentrationserhöhung der wirksamen Substanz, was dann zur Steuerung des Anätzprozesses der Oberfläche ausgenutzt wird. Die ätzwirksame Substanz ist im Falle von $Al_2O_3$-Keramik eine starke Base, die beispielsweise durch Hydrolyse von Natriumamid entsteht und im wesentlichen durch die Konzentrationen von $H_2O$ und $NH_2^-$ bzw. $OH^-$ entsprechend der Reaktionsgleichung $NaNH_2 + H_2O = NaOH +$

NH$_3$ gekennzeichnet ist.

Es wurde in diesem Zusammenhang gefunden, daß sich insbesondere das Agens Natriumhydroxid je nach dem Typ seiner Entstehungsreaktion sowie seiner Konzentration, je nach Lage des entsprechenden chemischen Gleichgewichts bzw. Verdünnung durch Reaktionsprodukte oder auch Aktivierung durch bestimmte Zusätze über einen weiten Bereich in seiner Ätzstärke vorbestimmen läßt.

Die Erfindung soll an Hand folgender Ausführungsbeispiele näher erläutert werden :

Beispiel 1

Aluminiumoxid-Keramikplättchen (99,5 % Al$_2$O$_3$, 0,6 × 50,8 × 50,8 mm$^3$) werden 10 min lang in eine Schmelze von Natriumamid bei 250 °C getaucht. Nach dem Herausziehen werden diese im noch heißen Zustand für 5 min über einem Gefäß mit siedendem Wasser aufgehängt. Danach werden sie in einem Rohrofen in kohlendioxidfreier Atmosphäre bei einer Temperatur von 300 °C 12 min lang getempert. Nach Abkühlung und intensiver Wasserspülung werden die Keramikproben nach dem bekannten Zinnsalz-/Palladiumsalzverfahren mit katalytischen Keimen belegt und stromlos-chemisch aus einem derzeit handelsüblichen chemischen Kupferbad mit einer ungefähr 0,2 µm dicken Kupferbasisschicht versehen. Nach einer Zwischenspülung wird aus einem derzeit handelsüblichen galvanischen Kupfersulfatbad auf ungefähr 12 µm Schichtdicke mit Kupfer verstärkt. Zur Haftfestigkeitsprüfung werden auf fotoätztechnischem Wege 1 mm breite Kupferstreifen erzeugt und daran mit einer Zugprüfmaschine die Trennkräfte zum senkrechten Abschälen dieser Streifen gemessen. Die Schälfestigkeiten betragen ungefähr 0,8 N/mm.

Beispiel 2

Keramikplättchen aus Al$_2$O$_3$ werden unter einem Abzug für 10 min in eine Schmelze von Natriumformiat bei 290 °C getaucht. Nach dem Herausziehen aus der Schmelze werden die Proben in einem Rohrofen für 3 min unter Stickstoff bei 450 °C getempert. Danach können die Proben an Luft abkühlen, werden gründlich mit Wasser gespült und wie in Beispiel 1 bekeimt, stromloschemisch und schließlich galvanisch mit ungefähr 12 µm Kupfer metallisiert. Schälkraftmessungen an präparierten Streifen erbrachten Werte von ungefähr 0,7 N/mm.

Die Erfindung ist nicht auf die Ausführungsbeispiele beschränkt, sondern sinngemäß auf weitere anwendbar, die sich insbesondere aus den in den Unteransprüchen genannten Materialien ergeben.

**Patentansprüche**

1. Verfahren zur Metallisierung eines elektrisch schlecht leitenden Substrates aus einem anorganischen Material, insbesondere zur Metallisierung eines Substrates aus Keramik, bei welchem vor der Metallisierung auf eine zu metallisierende Oberfläche des Substrates zunächst ein Vorbehandlungsmittel als gleichmäßige Schicht aufgebracht wird und bei welchem das Vorbehandlungsmittel während einer nachfolgenden thermischen Behandlung ein Aufrauhen und/oder Anätzen der Oberfläche bewirkt, dadurch gekennzeichnet,

daß ein Vorbehandlungsmittel, welches nach einer chemischen Umwandlung die Oberfläche chemisch aufschließt und welches von dem Material des Substrates sowie einer auf dessen Oberfläche zu erzeugenden Rauhtiefe abhängt, gewählt wird und

daß durch eine Nachbehandlung des Vorbehandlungsmittels auf der Oberfläche eine chemische Reaktion, durch welche eine die Oberfläche ätzend angreifende Substanz gebildet wird, bewirkt wird.

2. Verfahren nach Anspruch 1, dadurch gekennzeichnet, daß das Vorbehandlungsmittel aus einer gegenüber dem Material des Substrates niedrig schmelzenden Verbindung besteht, die als Schicht aufgebracht wird oder daß das Vorbehandlungsmittel als schichtbildende Lösung ausgebildet wird.

3. Verfahren nach Anspruch 1 oder Anspruch 2, dadurch gekennzeichnet, daß in dem Vorbehandlungsmittel als niedrig schmelzende Verbindung ein Oxid, Peroxid, Hydrid, Amid, Imid, Nitrid, Borat, Carbonat, Phosphat, Nitrat, Nitrit, Alkoholat, Formiat, Acetat, Oxalat, Phthalat, Lactat, Citrat, Tartrat und/oder eine weitere durch eine chemische Reaktion alkalisch reagierende anorganische oder organische Verbindung verwendet wird.

4. Verfahren nach Anspruch 3, dadurch gekennzeichnet, daß die alkalisch reagierende anorganische oder organische Verbindung ein Alkali- oder Erdalkalimetall, Ammonium oder seine organischen Derivate allein oder ein eutektisches Gemisch von zwei oder mehreren der Verbindungen enthält.

5. Verfahren nach einem der vorhergehenden Ansprüche, dadurch gekennzeichnet, daß als Vorbehandlungsmittel eine metallorganische Verbindung, vorzugsweise eine alkalimetallorganische Verbindung, in Lösung verwendet wird.

6. Verfahren nach einem der vorhergehenden Ansprüche, dadurch gekennzeichnet, daß bei dem Vorbehandlungsmittel als Beschichtungsverfahren für Schmelzen ein Eintauch- sowie Ausziehverfahren mit konstanter Geschwindigkeit oder ein Pulveraufbringungs- oder ein Panier-Verfahren oder ein Pastenaufstrich- oder Pastendruckverfahren verwendet wird, während für weniger viskose, vor allem wässrige Lösungen, Sprühverfahren verwendet werden, oder daß ein Schleuderätz- oder Schaumätz- oder Gasätzverfahren verwendet wird.

7. Verfahren nach einem der vorhergehenden Ansprüche, dadurch gekennzeichnet, daß das Vorbehandlungsmittel als niedrig schmelzende Verbindung ein Alkaliamid enthält und daß die Nachbehandlung als Hydrolysereaktion ausgeführt wird, bei der ein Alkalihydroxid sowie Ammoniak erzeugt werden.

8. Verfahren nach einem der vorhergehenden Ansprüche, dadurch gekennzeichnet, daß das Vorbehandlungsmittel als Paste ausgebildet wird, bestehend aus einem pulverisierten Alkalihydroxid und einem höhermolekularen, vorzugsweise mehrwertigen Alkohol und/oder Paraffinöl.

9. Verfahren nach einem der vorhergehenden Ansprüche, dadurch gekennzeichnet, daß als Vorbehandlungsmittel eine Lösung von Naphthalinnatrium in Tetrahydrofuran verwendet wird.

10. Verfahren nach einem der vorhergehenden Ansprüche, dadurch gekennzeichnet, daß das Vorbehandlungsmittel mit Hilfe einer Maske lediglich teilweise auf die Oberfläche aufgebracht wird und daß damit lediglich ein Teil der Oberfläche angeätzt wird.

11. Verfahren nach einem der vorhergehenden Ansprüche, dadurch gekennzeichnet, daß zur Erzielung einer optimalen Dichte an Ätzverankerungsvertiefungen zusätzlich eine Vorbehandlung der Substratoberfläche durch mechanische Aufrauhung erfolgt, um so aktive Störungszentren in oberflächennahen Schichten zu erzeugen, die eine bevorzugte Ätzung erlauben.

12. Verfahren nach Anspruch 11, dadurch gekennzeichnet, daß die mechanische Aufrauhung durch Sandstrahlen erfolgt.

## Claims

1. Method for metallising an electrically poorly conducting substrate of an inorganic material, in particular for the metallising of a substrate of ceramic, in which method a preliminary treatment agent is initially before the metallising applied as uniform layer onto a surface, to be metallised, of the substrate and in which the preliminary treatment agent during a subsequent thermal treatment effects a roughening and/or etching of the surface, characterised thereby,

that a preliminary treatment agent is chosen, which after a chemical conversion decomposes the surface chemically and which depends on the material of the substrate as well as a depth of roughness to be produced on its surface, and

that a chemical reaction, through which a substance is formed, which etchingly attacks the surface, is caused on the surface by a further treatment of the preliminary treatment agent.

2. Method according to claim 1, characterised thereby, that the preliminary treatment agent consists of a compound, which has a low melting point compared with the material of the substrate and is applied as layer, or that the preliminary treatment agent is developed as layer-forming solution.

3. Method according to claim 1 or 2, characterised thereby, that an oxide, peroxide, hydride, amide, imide, nitride, borate, carbonate, phosphate, nitrate, nitrite, alcoholate, formate, acetate, oxalate, phthalate, lactate, citrate, tartrate and/or a further inorganic or organic compound, which reacts alkalinely through a chemical reaction, is used as compound of low melting point in the preliminary treatment agent.

4. Method according to claim 3, characterised thereby, that the alkalinely reacting inorganic or organic compound contains an alkali metal or an alkaline earth metal, ammonium or its organic derivatives alone or a eutectic mixture of two or more of the compounds.

5. Method according to one of the preceding claims, characterised thereby, that a chelate compound, preferably an alkaline chelate compound, is used in solution as preliminary treatment agent.

6. Method according to one of the preceding claims, characterised thereby, that as coating process for the preliminary treatment agent, an immersion as well as extraction process at constant speed or a powder application or coating process or a paste-brushing or paste-printing process is used for melts, whilst spraying processes are used for less viscous, above all aqueous solutions or that a centrifuging etching or foam etching or gas etching process is used.

7. Method according to one of the preceding claims, characterised thereby, that the preliminary treatment agent as compound of low melting point contains an alkali amide and that the further treatment is carried out as hydrolysis reaction, in which an alkali hydroxide as well as ammonia are produced.

8. Method according to one of the preceding claims, characterised thereby, that the preliminary treatment agent is formed as paste consisting of a pulverised alkali hydroxide and a higher molecule, preferably multivalent alcohol and/or paraffin oil.

9. Method according to one of the preceding claims, characterised thereby, that a solution of naphthalene sodium in tetrahydrofuran is used as preliminary treatment agent.

10. Method according to one of the preceding claims, characterised thereby, that the preliminary treatment agent is applied merely partially to the surface with the aid of a mask and that thereby merely a part of the surface is etched.

11. Method according to one of the preceding claims, characterised thereby, that for the achievement of an optimum density of etch anchoring pits, a preliminary treatment of the substrate surface takes place additionally by mechanical roughening in order thus to produce active fault centres in layers near to the surface, which permit a preferred etching.

12. Method according to claim 11, characterised thereby, that the mechanical roughening takes place by sand-blasting.

## Revendications

1. Procédé pour la métallisation d'un substrat mauvais conducteur de l'électricité en matière inorganique, en particulier pour la métallisation d'un substrat en céramique, dans lequel on applique d'abord, avant la métallisation, un agent de prétraitement en couche uniforme sur une surface à métalliser du substrat et dans lequel l'agent de prétraitement corrode et/ou décape la surface pendant un traitement thermique ultérieur, caractérisé

en ce que l'on choisit un agent de prétraitement, qui attaque chimiquement la surface après une transformation chimique et qui dépend de la matière du substrat, ainsi que d'une profondeur de rugosité à produire à sa surface et

en ce qu'un post-traitement de l'agent de prétraitement provoque à la surface une réaction chimique qui produit une substance attaquant la surface par corrosion.

2. Procédé selon la revendication 1, caractérisé en ce que l'agent de prétraitement consiste en une substance de bas point de fusion, par rapport à la matière du substrat, qui est appliquée en couche ou en ce que l'agent de prétraitement est sous forme de solution filmogène.

3. Procédé selon la revendication 1 ou 2, caractérisé en ce que l'on utilise comme substance de bas point de fusion dans l'agent de prétraitement un oxyde, un peroxyde, un hydrure, un amidure, un imidure, un nitrure, un borate, un carbonate, un phosphate un nitrate, un nitrite, un alcoolate, un formiate, un acétate, un oxalate, un phtalate, un lactate, un citrate, un tartrate et/ou une autre substance inorganique ou organique produisant une réaction alcaline par réaction chimique.

4. Procédé selon la revendication 3, caractérisé en ce que le composé inorganique ou organique à réaction alcaline contient un métal alcalin ou alcalino-terreux ou un ion ammonium ou ses dérivés organiques seuls ou un mélange eutectique de deux ou plusieurs de ces composés.

5. Procédé selon l'une des revendications précédentes, caractérisé en ce que l'on utilise comme agent de pretraitement un composé organométallique, de préférence un composé organique de métal alcalin, en solution.

6. Procédé selon l'une des revendications précédentes, caractérisé en ce que l'on utilise avec l'agent de prétraitement comme procédé d'enduction pour masses fondues un procédé d'immersion et d'extraction à vitesse constante ou un procédé d'application de poudre ou un procédé de saupoudrage ou un procédé d'étalement en pâte ou d'impression à la pâte, tandis que pour des solutions moins visqueuses, surtout des solutions aqueuses, on utilise des procédés par pulvérisation, ou en ce que l'on utilise un procédé de gravure à la tournette ou un procédé de gravure par mousse ou un procédé de gravure par un gaz.

7. Procédé selon l'une des revendications précédentes, caractérisé en ce que l'agent de prétraitement contient comme composé de bas point de fusion un amidure alcalin et en ce que le traitement ultérieur est réalisé comme réaction d'hydrolyse, dans laquelle il se produit un hydroxyde alcalin ainsi que de l'ammoniac.

8. Procédé selon l'une des revendications précédentes, caractérisé en ce que l'agent de prétraitement est sous forme de pâte, consistant en un hydroxyde alcalin pulvérisé et un alcool, de préférence polyfonctionnel, de haut poids moléculaire et/ou une huile de paraffine.

9. Procédé selon l'une des revendications précédentes, caractérisé en ce que l'on utilise comme agent de prétraitement une solution de naphtalène-sodium dans le tétrahydrofuranne.

10. Procédé selon l'une quelconque des revendications précédentes, caractérisé en ce que l'agent de prétraitement n'est appliqué que partiellement sur la surface au moyen d'un masque et en ce que l'on n'attaque donc qu'une partie de la surface.

11. Procédé selon l'une des revendications précédentes,. caractérisé en ce que, pour obtenir une densité optimale d'empreintes d'ancrage d'attaque, on effectue en outre un prétraitement de la surface du substrat par décapage mécanique, pour produire ainsi dans les couches voisines de la surface des centres de perturbation, qui permettent une attaque préférée.

12. Procédé selon la revendication 11, caractérisé en ce que l'on effectue le décapage mécanique au jet de sable.